(19) Europäisches Patentamt
European Patent Office
Office européen des brevets

(11) Publication number: **0 256 664 B1**

(12) **EUROPEAN PATENT SPECIFICATION**

(45) Date of publication of patent specification :
27.11.91 Bulletin 91/48

(51) Int. Cl.⁵: **H01S 3/06, H01L 33/00**

(21) Application number : 87306183.2

(22) Date of filing : 13.07.87

(54) Distributed-feedback type semiconductor laser devices.

(30) Priority : 28.07.86 JP 177372/86

(43) Date of publication of application :
24.02.88 Bulletin 88/08

(45) Publication of the grant of the patent :
27.11.91 Bulletin 91/48

(84) Designated Contracting States :
DE FR GB NL

(56) References cited :
EP-A- 0 182 508
PATENT ABSTRACTS OF JAPAN, vol. 7, no.
258 (E-211)[1403], 17th November 1983 & JP-
A-58 143 595
PATENT ABSTRACTS OF JAPAN, vol. 8, no.
194 (E-264)[1631], 6th September 1984 & JP-
A-59 80 984
PATENT ABSTRACTS OF JAPAN, vol. 9, no.
159 (E-326)[1882], 4th July 1985 & JP-A-60 37
793

(56) References cited :
TOUTE L'ELECTRONIQUE, no. 514, May 1986,
pages 5,6,8, Paris, FR; "Panorama technique:
Composants opto-électroniques pour modu-
lation multigigahertz"
IEEE JOURNAL OF QUANTUM ELECTRONICS,
vol. QE-22, no. 7, July 1986, pages 1042-1051,
IEEE, New York, US; K. UTAKA et al.:
"Lamda/4-shifted InGaAsP/InP DFB lasers"

(73) Proprietor : SONY CORPORATION
7-35 Kitashinagawa 6-Chome Shinagawa-ku
Tokyo 141 (JP)

(72) Inventor : Hirata, Shoji c/o Patents Division
Sony Corporation 6-7-35 Kitashinagawa
Shinagawa-ku Tokyo 141 (JP)
Inventor : Honda, Kasuo c/o Patents Division
Sony Corporation 6-7-35 Kitashinagawa
Shinagawa-ku Tokyo 141 (JP)

(74) Representative : Thomas, Christopher Hugo et
al
D Young & Co 10 Staple Inn
London WC1V 7RD (GB)

## Description

This invention relates to distributed-feedback type semiconductor laser devices and to methods of producing such laser devices.

In previously proposed distributed-feedback type semiconductor laser devices, a diffraction grating is formed all over the surface of a guide layer disposed adjacent to an active region of the laser device which includes an active layer to provide for single longitudinal mode operation. On the other hand, single transverse mode operation by a refractive index wave guide is achieved by the use of a structure formed externally at a position apart from the diffraction grating after all crystal growth has been completed.

The foregoing previously proposed structure requires additional crystal growth and other manufacturing steps which give rise to problems that need to be solved. For example, a buried heterostructure type distributed-feedback semiconductor laser device requires that crystal growth be effected three times. During the third crystal growth period, a crystal is grown in an inverted mesa form, which results in problems involving the boundary at which a leakage current can occur if the boundary is badly formed, the current path, controllability of the p-n junction produced by diffusion of dopants when heat treatment is effected for a long time, and so on. On the other hand, in a ridge structure-type distributed-feedback semiconductor laser device, the refractive index wave guide characteristic depends largely on the thickness of an active region arranged at opposite sides of a ridge structure, and on the ridge width. Therefore, the production of the ridge structure must be precisely controlled.

It has been proposed in Japanese laid-open patent publication 59/80984 to provide a surface illuminant distributed-feedback type semiconductor laser device in which a periodic uneven surface, that is, a diffraction grating, is formed on the surface of a light guiding layer. Then, the surface of the light guiding layer other than a striped-shaped region extending in the forward direction of the laser light, is etched to a depth short of the underlying active layer, with the object of obtaining plane regions at the etched surface portion, whereupon, a cladding layer is grown on the light guiding layer. However, since the desired plane regions are obtained by etching surface portions on which the diffraction grating has earlier been formed, wave-shaped wrinkles inevitably remain in the nominally plane regions. The clad layer cannot be satisfactorily grown on the wrinkled plane regions of the guiding layer, and this adversely influences the useful life of the laser device and the stability of its operation.

In Japanese patent application 61/141137, a distributed-feedback type semiconductor laser device has been proposed in which an active layer is interposed between a pair of clad layers, and a stripe-shaped distributed feedback means formed by a diffraction grating is formed in a guide layer on the active layer, while surface portions of the guide layer at opposite sides of the stripe-shaped diffraction grating are maintained substantially planar, that is, wrinkle free. Since the guide layer surface portions at opposite sides of the stripe-shaped diffraction grating are planar, each crystal layer grown successively on the guide layer after the diffraction grating has been formed can be provided with good crystallinity for prolonging the useful life of the semiconductor laser device and improving the stability of its operation. However, if the diffraction grating is formed only on a narrow region of the guide layer, as in the foregoing proposal, it is difficult to control the manufacturing conditions so as to ensure the uniform formation of the diffraction grating with good reprocibility.

According to the present invention there is provided a distributed-feedback type semiconductor laser device comprising:

a pair of cladding layers;

an active layer interposed between said pair of cladding layers;

stripe-shaped distributed-feedback means on said active layer; and

relatively narrow plane regions extending along opposite sides of said distributed-feedback means; characterized by:

dummy regions at opposite sides of said distributed-feedback means and having the same configuration as said distributed-feedback means with said plane regions dividing said dummy regions from said distributed-feedback means.

According to the present, invention there is also provided a method of making a distributed-feedback type semiconductor laser device, the method comprising:

sequentially epitaxially growing, on a substrate, a cladding layer, an active layer and a guide layer; and

coating a photo-resist layer on said guide layer; characterized by:

effecting a first exposure of said photo-resist layer through a photo-mask along a pair of relatively narrow, stripe-like, parallel spaced-apart areas;

effecting holographic exposure of said photo-resist layer at the areas thereof other than said stripe-like areas so as to provide a latent image of a diffraction grating on said other areas;

developing the exposed photo-resist layer so as to form a resist-mask therefrom;

selectively etching said guide layer through said resist mask so that said guide layer forms a stripe-shaped distributed-feedback means on said active layer, relatively narrow plane regions extending along opposite sides of said distributed-feedback means, and dummy regions at opposite sides of said distributed-feedback means and having the same configuration as said distributed-feedback means with said plane

2

regions dividing said dummy regions from said distributed-feedback means; and
epitaxially growing a cladding layer on the etched
guide layer.

The invention will now be described by way of
example with reference to the accompanying drawings, throughout which like parts are referred to by like
references, and in which:

Figure 1 is a cross-sectional view of a previously
proposed distributed-feedback type semiconductor laser device;

Figure 2 is a sectional view taken along the line
II-II in Figure 1;

Figure 3 is a fragmentary perspective view showing a portion of the laser device of Figures 1 and
2;

Figure 4 is a cross-sectional view similar to that
of Figure 1, but showing an embodiment of distributed-feedback type semiconductor laser
device according to the present invention;

Figure 5 is a sectional view taken along the line
V-V in Figure 4;

Figure 6 is a fragmentary perspective view showing a portion of the laser device of Figures 4 and
5;

Figures 7A to 7E are schematic sectional views
illustrating successive steps in a method according to the present invention of making a distributed-feedback type semiconductor laser
device; and

Figure 8 is a plan view showing a photo-mask
used in a step of the method illustrated in Figure
7B.

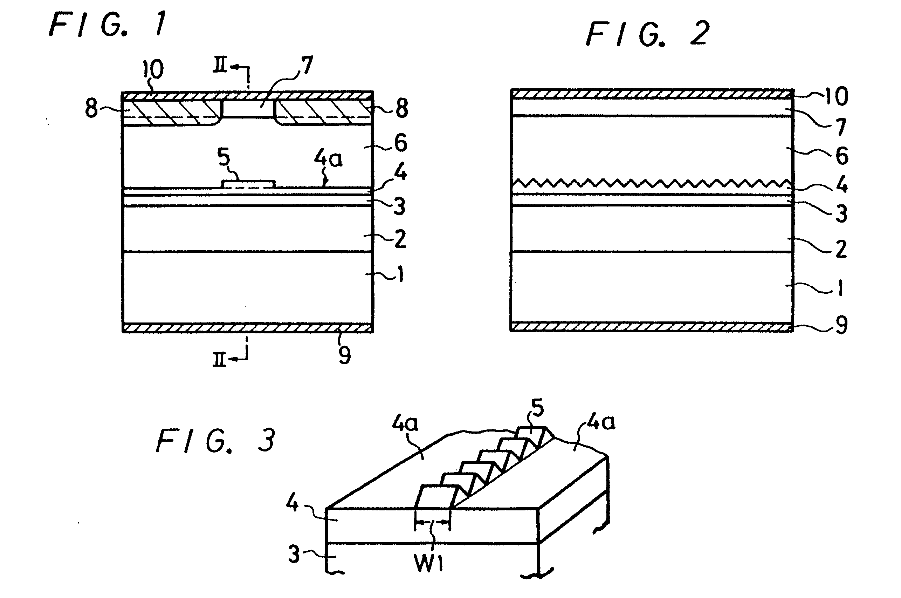

In order that the problems solved by embodiments of the present invention may be fully understood, a previously proposed distributed-feedback
type semiconductor laser device as disclosed in
Japanese patent application 61/141137 will now be
described with reference to Figures 1 to 3. The laser
device includes a p-type substrate 1 of GaAs on which
there are formed, in succession, a p-type cladding
layer 2 of AlGaAs, an active layer 3 of GaAs, an n-type
guide layer 4 of AlGaAs, an n-type cladding layer 6 of
AlGaAs and an n-type cap layer 7 of GaAs. Alternatively, the substrate 1 may be n-type, in which case
the cladding layer 2 is n-type and the guide layer 4,
the cladding layer 6 and the cap layer 7 are each p-
type. A stripe-shaped distributed-feedback means
formed by a diffraction grating 5 is formed centrally on
the guide layer 4, while surface portions 4a of the
guide layer 4 at opposite sides of the stripe-shaped
diffraction grating 5 are maintained in a planar form.
Ion implanted regions 8 extend through the opposite
side regions of the cap layer 7 into the cladding layer
6, and result from the implanting therein of ions, such
as protons or boron. Ohmic electrodes 9 and 10 are
provided on the substrate 1 and the cap layer 7, respectively.

The diffraction grating 5 extends in the forward
direction of the laser light, so that the laser device is
operated in the single longitudinal mode and the
transverse mode. Since the guide layer surfaces 4a at
the opposite sides of the diffraction grating 5 are planar, each crystal layer grown thereon, for example,
the cladding layer 6, after the formation of the diffraction grating 5 can be formed with good crystallinity
thereby to prolong the useful life of the laser device
and to improve its stability of operation.

The diffraction grating 5 has a pitch in the range
from 0.1 to 0.2μm and is preferably formed on the
guide layer 4 by the use of a holographic exposure
method employing the interference of two ultraviolet
laser light sources. However, in order to form a
uniform and noise-free diffraction grating of substantial size, it is necessary to control the manufacturing
conditions precisely, in particular the exposure,
development and etching.

However, in the previously proposed laser device
of Figures 1 to 3, the diffraction grating 5 is formed
only on a narrow area having a width W1 which
ranges from 2.0 to 5.0μm. It is therefore difficult to
effect the requisite precise control of the manufacturing conditions, with the result that it is extremely difficult to form the diffraction grating 5 uniformly with the
degree of reproducibility necessary for obtaining an
acceptable yield.

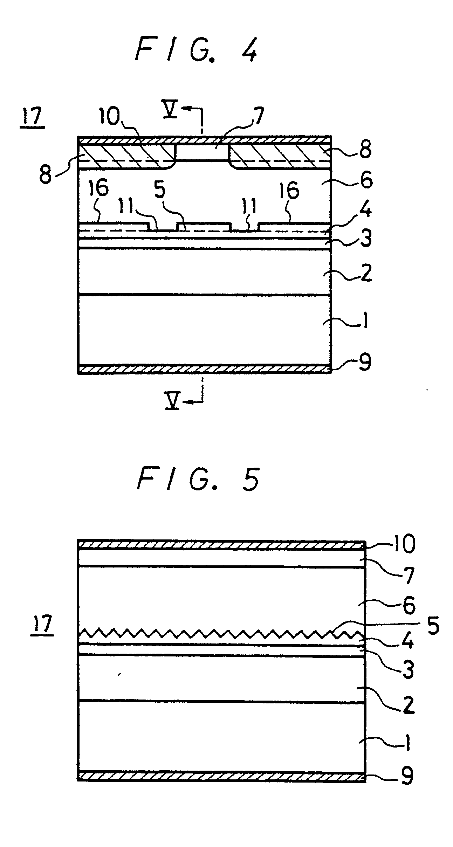

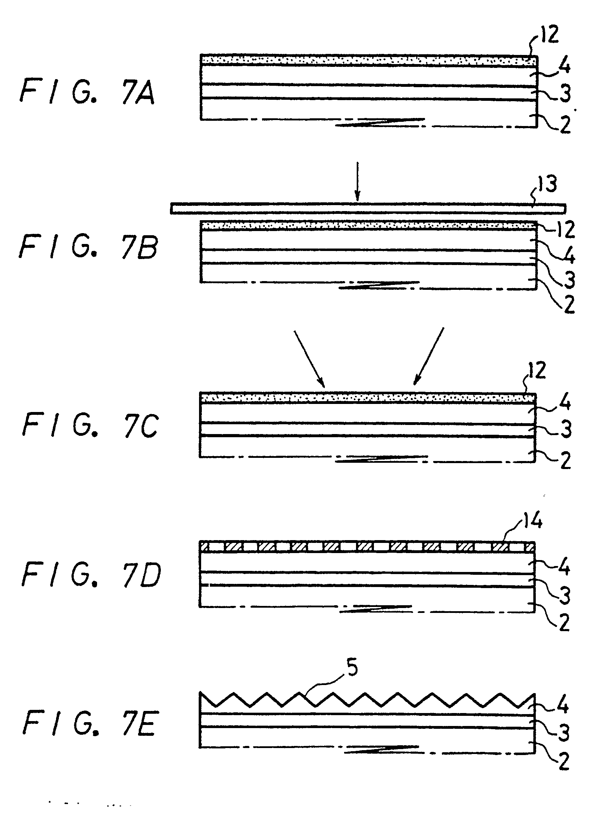

Referring now to Figures 4 and 5, it will be seen
that, in an embodiment of distributed-feedback type
semiconductor laser device according to the present
invention, a cladding layer 2 of p-type AlGaAs, an
active layer 3 of GaAs and a guide layer 4 of n-type
AlGaAs, are sequentially epitaxially grown on a substrate 1 of p-type GaAs. Then, as shown on Figure 7A,
a positive type photo-resist layer 12 is coated on the
guide layer 4, and a first exposure of the photo-resist
layer 12 is effected through a photo-mask 13, as illustrated in Figure 7B. As shown in Figure 8, the photo-
mask 13 has relatively narrow, stripe-like, parallel
spaced-apart transparent areas 13a while the remainder of the photo-mask 13 is of a light shielding or opaque material forming opaque areas 13b. In the case
where two semiconductor laser devices are being
simultaneously produced, the photo-mask 13 is
dimensioned to correspond to two semiconductor
laser devices arrayed side-by-side, and two pairs of
the stripe-like transparent areas 13a are laterally centred in the portions of the photo-mask 13 at opposite
sides of the longitudinal median line A-A thereof. It will
be appreciated that during the first exposure illustrated in Figure 7B, the photo-resist layer 12 is exposed only along the relatively narrow transparent
areas 13a of the photo-mask 13.

Thereafter, as illustrated in Figure 7C, the photo-
resist layer 12 is subjected to holographic exposure,
for example, by means of a two-beam interference
method employing a 351.1 nm line of an Ar+ laser light source, so as to provide a latent image of a diffraction grating on portions of the photo-resist layer 12. Since those portions of the photo-resist layer 12 corresponding to the transparent areas 13a of the photo-mask 13 have already been exposed in the course of the first exposure, the interference fringe is not formed on such portions of the photo-resist layer 12. In other words, the latent image of a diffraction grating is only formed on those portions of the photo-resist layer 12 which correspond to the opaque areas 13b of the photo-to-mask 13. At this time, it should be noted that the order of the first exposure illustrated in Figure 7B and the second or holographic exposure illustrated in Figure 7C may be reversed or interchanged.

The exposed photo-resist layer 12 is suitably developed to form a resist-mask 14, as shown in Figure 7D. The conditions employed for such development of the exposed photo-resist layer 12 may be substantially the same as those used previously when a diffraction grating is formed all over the entire surface of the guide layer 4.

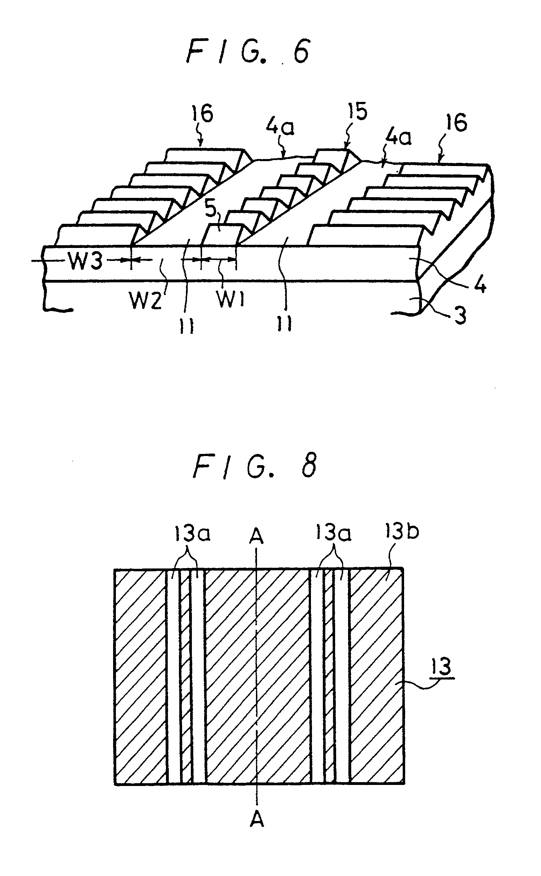

Then, as illustrated in Figure 7E, the guide layer 4 is selectively etched by an appropriate etching liquid acting through the developed resist-mask 14. The conditions for such etching may also be the same as those employed previously in forming a diffraction grating over the entire surface of the guide layer 4 in a semiconductor laser device. By virtue of the selective etching, an elongated, raised rib-like structure 15 is formed with a narrow striped shaped and, simultaneously, the surface of the rib structure 15 is formed with a periodic uneven or sawtooth pattern or configuration that defines the diffraction grating 5 extending in the forward direction of the laser light. At the opposite sides of the rib structure 15, elongated plane surface portions 4a corresponding to the elongated transparent areas 13a of the photo-mask 13 are etched away to a depth corresponding to the valleys of the sawtooth pattern forming the diffraction grating 5 and form relatively narrow plane regions 11. Moreover, the selective etching forms dummy regions 16 (Figures 4 and 6) at opposite sides of the diffraction grating 5 and having the same configuration or sawtooth pattern, with the dummy regions 16 being divided from the diffraction grating 5 by the plane regions 11 and forming a major portion of the surface of the etched guide layer 4. As is clearly shown in Figure 6, the maximum depth to which the guide layer 4 is etched, and which corresponds to the plane regions 11 and the valleys of the diffraction gratings 5 and 16, is less than the original thickness of the guide layer 4, so that the etching does not reach into the active layer 3 underlying the guide layer 4.

In the manufacture of a distributed-feedback type semiconductor laser device embodying the present invention, for example, the width W1 of the stripe-shaped diffraction grating 5 forming the distributed-feedback means may be from 2.0 to 5.0 μm, the width W2

of each of the plane regions 11 may be approximately 10.0 μm, and the width W3 of each of the dummy regions 16 may be approximately 270 μm.

Following the etching operation, the resist-mask 14 is suitably removed and a cladding layer 6 of n-type AlGaAs and a cap layer 7 of n-type GaAs are epitaxially grown, in succession, on the etched guide layer 4 formed with a refraction index wave guide mechanism and a distributed-feedback mechanism. Next, protons, boron or other like ions are implanted into the cap layer 7 and the immediate underlying portion of the cladding layer 6 across the width of the laser device with the exception of the central portion thereof corresponding to the width of the diffraction grating 5 so as to form an ion implanted layer 8. Finally, the ohmic electrodes 9 and 10 are formed on the free surfaces of the substrate 1 and the cap layer 7 to complete the distributed-feedback type semiconductor laser device 17 as shown in Figures 4 and 5. As previously noted, the photo-mask 13 illustrated in Figure 8 is intended for the simultaneous manufacture of two semiconductor laser devices. Thus, at the completion of the manufacturing operations described above, the resulting structure is divided or severed at a plane corresponding to the line A-A in Figure 8 so as to obtain two identical laser devices 17.

As described above, the dummy regions 16 formed at opposite sides of the stripe-shaped diffraction grating 5 and separated therefrom by the elongated plane regions 11 have the same configuration as the diffraction grating 5. In other words, the plane regions 11 are the only portions of the guide layer 4 in which the diffraction grating 5 is not formed, and such plane regions 11 are narrow in comparison with the regions 5 and 16 having the diffraction gratings.

By reason of the foregoing, the exposure, development and etching conditions for forming the stripe-shaped diffraction grating 5 can be substantially the same as the conditions employed for effecting such operations in the manufacture of the previously proposed laser devices having the diffraction grating extending over the entire surface of the guide layer. Thus, it is possible to control the conditions for forming the stripe-shaped diffraction grating 5 in the same manner as such conditions are controlled when forming a diffraction grating over the entire area of the guide layer. As a result, the narrow stripe-shaped diffraction grating 5 of the laser device 17 according to this embodiment can be formed with good reproducibility. Moreover, since the diffraction gratings forming the dummy regions 16 do not serve any functional purpose in the completed device 17, the laser device 17 has the same operating characteristics as the laser device of Figures 1 to 3, and in which the diffraction grating is formed only on a narrow stripe-shaped area of the guide layer. In other words, the narrow stripe-shaped diffraction grating 5 can be formed with a yield comparable to that obtained when the diffraction grating is formed over the entire area of the guide layer, but the laser device 17 formed by a method in accordance with the invention has operating characteristics corresponding to those of the previously proposed laser devices in which a diffraction grating was formed only on a narrow stripe-shaped area of the guide layer.

More specifically, in respect to the above-mentioned operating characteristics of the embodiment, it is to be noted that a distributed-feedback mechanism is defined by the stripe-shaped diffraction grating 5 along the forward direction of the laser light, and that a refraction index wave guide mechanism is defined by the rib structure 15 formed simultaneously with the diffraction grating 5 on the guide layer 4, with the result that the laser device 17 is operable in single longitudinal and transverse modes. Moreover, since the plane regions 11 formed at opposite sides of the stripe-shaped diffraction grating 5 are coplanar with the valleys of the diffraction grating 5, the cladding layer 6 and the cap layer 7 can thereafter be epitaxially grown with satisfactory crystallinity, so that the useful life of the laser device 17 is substantially prolonged and the stability of its operation is improved.

As earlier noted, the resist-mask 14 is formed on the guide layer 4 by development thereof following a double exposure, and the diffraction grating 5 and the rib structure 15 are simultaneously formed by a single etching process. By reason of such single etching process, the singularity or individuality of the transverse mode by refraction index wave guiding and of the longitudinal mode by distributed feedback are assured. Since the embodiment of laser device 17 does not require excessive crystal growth or other manufacturing steps which can substantially influence the operational characteristics, such laser devices 17 can easily be manufactured with desirable operational characteristics being obtained.

In the embodiment described with reference to Figures 4 to 6, the rib structure 15 is raised relative to the adjacent plane regions 11 as a result of the use of a positive type photo-resist layer 12. However, a negative type photo-resist layer may be used, in which case the diffraction grating 5 will be depressed below the plane regions 11, that is, the plane regions 11 will be coplanar with the ridges of the sawtooth configurations defining the diffraction grating 5.

Although the above-described embodiment of the present invention has its various layers formed of GaAs and AlGaAs, it will be appreciated that the present invention can be similarly applied to distributed-feedback type semiconductor laser devices formed of other materials suitable therefor.

By way of summary, in the embodiment, the distributed-feedback means thereof is striped-shaped and has plane regions arranged at the opposite sides thereof so that single longitudinal and transverse modes of operation are available, the useful life of the laser device is prolonged and the stability of its operation is improved. Moreover, by providing dummy regions having the same configuration as the distributed-feedback means at relatively wide, non-functional regions outside the plane regions, it is possible to form the distributed feedback means in a narrow stripe-like region with good reproducibility, and without complicating the manufacturing process or adversely affecting the characteristics of the semiconductor laser device, so that a relatively high yield is obtainable.

## Claims

1. A distributed-feedback type semiconductor laser device (17) comprising:
   a pair of cladding layers (2, 6);
   an active layer (3) interposed between said pair of cladding layers (2, 6);
   stripe-shaped distributed-feedback means (5) on said active layer; and
   relatively narrow plane regions (11) extending along opposite sides of said distributed-feedback means (5); characterized by:
   dummy regions (16) at opposite sides of said distributed-feedback means (5) and having the same configuration as said distributed-feedback means (5) with said plane regions (11) dividing said dummy regions (16) from said distributed-feedback means (5).

2. A laser device (17) according to claim 1 wherein said configuration of the distributed-feedback means (5) and said dummy regions (16) each form a diffraction grating (5, 16).

3. A laser device (17) according to claim 2 wherein said distributed-feedback means (5), plane regions (11) and dummy regions (16) are formed in a guide layer (4) on said active layer (3).

4. A laser device (17) according to claim 3 wherein said stripe-shaped distributed-feedback means (5) and said dummy regions (16) are raised relative to said plane regions (11).

5. A laser device (17) according to claim 4 wherein said diffraction grating (5, 16) is formed by a sawtooth configuration having ridges raised relative to said plane regions (11) and valleys coplanar with said plane regions (11).

6. A method of making a distributed-feedback type semiconductor laser device (17), the method comprising:
   sequentially epitaxially growing, on a substrate, a cladding layer (2), an active layer (3) and a guide layer (4); and coating a photo-resist layer (12) on said guide layer (4); characterized by:
   effecting a first exposure of said photo-resist layer (12) through a photo-mask (13) along a pair of relatively narrow, stripe-like, parallel spaced-apart areas (11);

effecting holographic exposure of said photo-resist layer (12) at the areas (5, 16) thereof other than said stripe-like areas so as to provide a latent image of a diffraction grating on said other areas (5, 16);

developing the exposed photo-resist layer so as to form a resist-mask (14) therefrom;

selectively etching said guide layer (4) through said resist-mask (14) so that said guide layer (4) forms a stripe-shaped distributed-feedback means (5) on said active layer (3), relatively narrow plane regions extending along opposite sides of said distributed-feedback means (5), and dummy regions (16) at opposite sides of said distributed-feedback means (5) and having the same configuration as said distributed-feedback means (5) with said plane regions (11) dividing said dummy regions (16) from said distributed-feedback means (5); and

epitaxially growing a cladding layer (6) on the etched guide layer (4).

## Patentansprüche

1. Eine Halbleiterlaservorrichtung (17) mit verteilter Rückkopplung mit:

zwei Deckschichten (2,6);

einer aktiven Schicht (3), die zwischen den beiden Deckschichten (2,6) angeordnet ist;

einer streifenförmigen Einrichtung (5) für verteilte Rückkopplung auf der aktiven Schicht; und

relativ schmalen ebenen Bereichen (11), die sich längs entgegengesetzter Seiten der Einrichtung (5) für verteilte Rückkopplung erstrecken;

gekennzeichnet durch:

Blindbereiche (16) an entgegengesetzten Seiten der Einrichtung (5) für verteilte Rückkopplung und mit der gleichen Konfiguration wie die Einrichtung (5) für verteilte Rückkopplung, wobei die ebenen Bereiche (11) die Blindbereiche (16) von der Einrichtung (5) für verteilte Rückkopplung trennen.

2. Eine Laservorrichtung (17) nach Anspruch 1, in welcher die Konfiguration der Einrichtung (5) für verteilte Rückkopplung und der Blindbereiche (16) je ein Beugungsgitter (5,16) bilden.

3. Eine Laservorrichtung (17) nach Anspruch 2, in welcher die Einrichtung (5) für verteilte Rückkopplung, die ebenen Bereiche (11) und die Blindbereiche (16) in einer Führungsschicht (4) auf der aktiven Schicht (3) geformt sind.

4. Eine Laservorrichtung (17) nach Anspruch 3, in welcher die streifenförmige Einrichtung (5) für verteilte Rückkopplung und die Blindbereiche (16) relativ zu den ebenen Bereichen (11) erhöht sind.

5. Eine Laservorrichtung (17) nach Anspruch 4, in welcher das Beugungsgitter (5,16) durch eine Sägezahn-Konfiguration gebildet ist, die relativ zu den ebenen Bereichen (11) erhöhte Kämme und mit den ebenen Bereichen (11) koplanare Täler aufweist.

6. Ein Verfahren zur Herstellung einer Halbleiterlaservorrichtung (17) mit verteilter Rückkopplung, welches Verfahren umfaßt:

sequentielles epitaxiales Aufwachsen einer Deckschicht (2), einer aktiven Schicht (3) und einer Führungsschicht (4) auf einem Substrat; und

Auftragen einer Photoresist-Schicht (12) auf der Führungsschicht (4);

gekennzeichnet durch:

Durchführung einer ersten Belichtung der Photoresist-Schicht (12) durch eine Photomaske (13) längs zweier relativ schmaler, streifenähnlicher, paralleler, gegenseitig beabstandeter Bereiche (11) hindurch;

Durchführung einer holographischen Belichtung der Photoresist-Schicht (12) in deren gegenüber den streifenähnlichen Bereichen anderen Bereichen (5,16), um ein latentes Abbild eines Beugungsgitters auf diesen anderen Bereichen (5,16) herzustellen;

Entwicklung der belichteten Photoresist-Schicht, um daraus eine Resist-Maske (14) zu bilden;

selektives Ätzen der Führungsschicht (4) durch die Resist-Maske (14) hindurch, so daß die Führungsschicht (4) eine streifenförmige Einrichtung (5) für verteilte Rückkopplung auf der aktiven Schicht (3) bildet, wobei sich relativ schmale ebene Bereiche längs entgegengesetzter Seiten der Einrichtung (5) für verteilte Rückkopplung und Blindbereiche (16) an entgegengesetzten Seiten der Einrichtung (5) für verteilte Rückkopplung und mit der gleichen Konfiguration wie die Einrichtung (5) für verteilte Rückkopplung erstrecken, und wobei die ebenen Bereiche (11) die Blindbereiche (16) von der Einrichtung (5) für verteilte Rückkopplung trennen;und epitaxiales Aufwachsen einer Deckschicht (6) auf der geätzten Führungsschicht (4).

## Revendications

1. Laser à semi-conducteur du type à rétroaction répartie (17), comprenant

une paire de couches (2, 6) de revêtement,

une couche active (3) disposée entre la paire de couches de revêtement (2,6),

un dispositif (5) à rétroaction répartie en forme de bande formé sur la couche active, et

des régions planes (11) relativement étroites disposées le long des côtés opposés du dispositif (5) à rétroaction répartie, caractérisé par

des régions factices (16) placées de part et d'autre du dispositif (5) à rétroaction répartie et ayant la même configuration que le dispositif (5) à rétroaction répartie, les régions planes (11) séparant les régions factices (16) du dispositif (5) à rétroaction répartie.

2. Laser (17) selon la revendication 1, dans lequel la configuration du dispositif (5) à rétroaction répartie et celle des régions factices (16) forment chacune un réseau de diffraction (5, 16).

3. Laser (17) selon la revendication 2, dans lequel le dispositif (5) à rétroaction répartie, les régions planes (11) et les régions factices (16) sont formées dans une couche de guidage (4) disposée sur la couche active (3).

4. Laser (17) selon la revendication 3, dans lequel le dispositif (5) à rétroaction répartie en forme de bande et les régions factices (16) sont en saillie par rapport aux régions planes (11).

5. Laser (17) selon la revendication 4, dans lequel le réseau de diffraction (5, 16) est formé avec une configuration en dents de scie ayant des arêtes en saillie par rapport aux régions planes (11) et des creux coplanaires aux régions planes (11).

6. Procédé de fabrication d'un laser (17) à semi-conducteur du type à rétroaction répartie, le procédé comprenant

la croissance épitaxiale successive, sur un substrat, d'une couche (2) de revêtement, d'une couche active (3) et d'une couche (4) de guidage, et

le revêtement de la couche (4) de guidage par une couche (12) d'un matériau de réserve photographique,

caractérisé par

une première exposition de la couche (12) du matériau de réserve photographique à travers un masque photographique (13) le long d'une paire de zones distantes, parallèles, relativement étroites et en forme de bande (11),

l'exposition holographique de la couche (12) du matériau de réserve photographique dans ses zones (5, 16) autres que les zones en forme de bande afin qu'une image latente d'un réseau de diffraction soit formée sur ses autres zones (5, 16),

le développement de la couche exposée du matériau de réserve photographique afin qu'un masque de matériau de réserve (14) soit formé,

l'attaque sélective de la couche (4) de guidage à travers le masque (14) du matériau de réserve afin que la couche de guidage (4) forme un dispositif (5) à rétroaction répartie en forme de bande sur la couche active (3), des régions planes relativement étroites étant disposées le long des côtés opposés du dispositif (5) à rétroaction répartie, et des régions factices (16) étant placées de part et d'autre du dispositif (5) à rétroaction répartie et ayant la même configuration que le dispositif (5) à rétroaction répartie, les régions planes (11) séparant les régions factices (16) du dispositif (5) à rétroaction répartie, et

la croissance épitaxiale d'une couche (6) de revêtement sur la couche attaquée (4) de guidage.

EP 0 256 664 B1

*FIG. 1*

*FIG. 2*

*FIG. 3*

## F I G. 4

## F I G. 5

# F I G. 6

16   4a   15   4a   16

5

W3   W2   W1   11   11   4   3

# F I G. 8

13a   A   13a   13b

13

A

A

F I G. 7A

F I G. 7B

F I G. 7C

F I G. 7D

F I G. 7E